(19) Europäisches Patentamt
European Patent Office
Office européen des brevets

(11) **EP 4 531 533 A1**

(12) **EUROPEAN PATENT APPLICATION**
published in accordance with Art. 153(4) EPC

(43) Date of publication:
**02.04.2025 Bulletin 2025/14**

(21) Application number: **24824729.8**

(22) Date of filing: **20.05.2024**

(51) International Patent Classification (IPC):
**H10N 97/00** (2023.01)    **H10B 12/00** (2023.01)

(52) Cooperative Patent Classification (CPC):
**H10B 12/00; H10N 97/00**

(86) International application number:
**PCT/CN2024/094149**

(87) International publication number:
**WO 2025/020652 (30.01.2025 Gazette 2025/05)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **25.07.2023  CN 202310924147
25.07.2023  CN 202321986642 U**

(71) Applicant: **SwaySure Technology Co., Ltd.
Shenzhen (CN)**

(72) Inventor: **HSIEH, Minghung
Shenzhen, Guangdong 518000 (CN)**

(74) Representative: **Studio Torta S.p.A.
Via Viotti, 9
10121 Torino (IT)**

(54) **CAPACITOR, MEMORY, AND METHOD FOR MANUFACTURING MEMORY**

(57)    The present application relates to a capacitor, a memory, and a manufacturing method of the memory. The capacitor includes a first electrode layer; a second electrode layer; and a strontium titanate dielectric layer formed between the first electrode layer and the second electrode layer, where in a direction from the center of the strontium titanate dielectric layer to two opposite sides of the strontium titanate dielectric layer, ratios of Sr/(Sr+Ti) in the strontium titanate dielectric layer decrease gradually, one side of the two opposite sides in the strontium titanate dielectric layer is close to the first electrode layer, and the other side of the two opposite sides in the strontium titanate dielectric layer is close to the second electrode layer.

FIG. 7

## Description

### CROSS-REFERENCE TO RELATED APPLICATIONS

The present application claims priority to Chinese patent application No. 202310924147.9, filed on July 25, 2023, entitled "Capacitor, Memory and Manufacturing Method of Memory" and Chinese patent application No. 202321986642.4, filed on July 25, 2023, entitled "Capacitor, Memory and Manufacturing Method of Memory", the disclosures of which are hereby incorporated by reference in their entirety.

### TECHNICAL FIELD

The present application pertains to the field of chips, and particularly relates to a capacitor, a memory and a manufacturing method of the memory.

### BACKGROUND

With the development of chip industry, there are increasingly high requirements on Dynamic Random Access Memory (DRAM) chips with higher storage density in the market. How to realize the higher storage density of the DRAM chip is a significant research topic in many chip industries.

As far as the DRAM chip including 1T1C (one transistor+1 capacitor) is concerned, the capacitor is an important factor which restrains critical size of the DRAM chip. How to improve the storage density of the DRAM on the premise of reducing the critical size to guarantee that the DRAM chip has an enough signal resolution, i.e., how to guarantee a higher dielectric constant (K value for short) and a lower leakage density of the capacitor becomes a problem needed to be solved urgently.

### SUMMARY

Embodiments of the present application provide a capacitor, a memory and a method manufacturing of the memory, which can realize an effect of high K value and low electric leakage.

a capacitor, which includes:

a first electrode layer;

a second electrode layer; and

a strontium titanate dielectric layer formed between the first electrode layer and the second electrode layer;

where in a direction from a center of the strontium titanate dielectric layer to two opposite sides of the strontium titanate dielectric layer, the ratios of Sr/(Sr+Ti) in the strontium titanate dielectric layer decrease gradually;

one side of the two opposite sides in the strontium titanate dielectric layer is close to the first electrode layer and the other side of the two opposite sides in the strontium titanate dielectric layer is close to the second electrode layer.

a memory, which includes a substrate and any one capacitor above, the capacitor being formed on the substrate.

A third aspect of the present application provides a manufacturing method of a memory, which may include:

providing a substrate;

forming a first electrode layer on the substrate;

forming a strontium titanate dielectric layer at a side of the first electrode layer away from the substrate, where in a direction from a center of the strontium titanate dielectric layer to two opposite sides of the strontium titanate dielectric layer, ratios of Sr/(Sr+Ti) in the strontium titanate dielectric layer decrease gradually, one side of the two opposite sides in the strontium titanate dielectric layer is close to the first electrode layer and the other side of the two opposite sides in the strontium titanate dielectric layer is away from the first electrode layer; and

forming a second electrode layer at a side of the strontium titanate dielectric layer away from the first electrode layer to form a capacitor.

The technical solution provided in the embodiments of the present application has at least the following advantages: the ratios of the Sr contents in the strontium titanate dielectric layer decrease gradually from the center of the strontium titanate dielectric layer to the direction of the two opposite sides of the strontium titanate dielectric layer and the ratios of the Ti contents in the strontium titanate dielectric layer increase gradually from the center of the strontium titanate dielectric layer to the direction of the two opposite sides of the strontium titanate dielectric layer, so that while the high Sr content in the overall strontium titanate dielectric layer is guaranteed to have a relatively high K value, the stress of the strontium titanate dielectric layer can be further favorably released or relaxed as it is easy to crystallize due to the high Sr content, i.e., the stress is gradually released from the center of the strontium titanate dielectric layer to both sides of the strontium titanate dielectric layer; by reducing the internal stress of the strontium titanate dielectric layer, cracks of the strontium titanate dielectric layer can be reduced, the surface uniformity of the strontium titanate dielectric layer is improved, and therefore, it has the low leakage performance.

## BRIEF DESCRIPTION OF THE DRAWINGS

The drawings, which are incorporated in and constitute a part of this specification, illustrate embodiments consistent with the present application and, together with the description, serve to explain the principles of the present application. It is apparent that the drawings described below are merely some embodiments of the present application, and those of ordinary skill in the art further can obtain other drawings according to those drawings without making creative efforts.

FIGs. 1-5 show schematic structural diagrams of memories corresponding to various solutions mentioned in Embodiment I of the present application.

FIG. 6 shows a three-dimensional schematic structural diagram of the memories mentioned in Embodiment I of the present application.

FIG. 7 shows a schematic structural diagram of a capacitor in a solution mentioned in Embodiment I of the present application.

FIGs. 8-10 show schematic diagrams of corresponding changes when the ratios of Sr/(Sr+Ti) in a strontium titanate dielectric layer are designed at different gradients in Embodiment I of the present application.

FIG. 11 shows a schematic structural diagram of a capacitor in another solution mentioned in Embodiment I of the present application.

FIGs. 12-14 show schematic structural diagrams of capacitors in various corresponding solutions in Embodiment II of the present application.

FIGs. 15-25 show schematic structural diagrams corresponding to steps in a manufacturing method of a memory provided in Embodiment III of the present application.

Reference numerals:

10, substrate;
100, semiconductor base;
101, insulation isolation layer;
11, capacitor;
11a, ruthenium element film layer;
11b, titanium nitride film layer;
110, first electrode layer;
111, dielectric layer;
111a, dielectric material film;
112, second electrode layer;
112a, second electrode material film;
1110, strontium titanate dielectric layer;

11101, strontium titanate film layer;
1111, first titanium oxide dielectric layer;
1112, second titanium oxide dielectric layer;
1113, first aluminum titanate dielectric layer;
1114, second aluminum titanate dielectric layer;
12, insulation dielectric layer;
13, etch stop layer;
14, measurement electrode material film;
14a, first measurement electrode;
14b, second measurement electrode;
140, via hole conduction portion;
141, measurement conduction portion;
15, interlevel dielectric layer;
150, through hole;
15a, interlevel dielectric material film;
16, transistor;
17, word line;
18, bit line;
19, first photoresist mask layer;
20, second photoresist mask layer;
21, first via;
22, second via;
23, third photoresist mask layer;
24, fourth photoresist mask layer.

## DETAILED DESCRIPTION OF THE EMBODIMENTS

The exemplary implementations will be described more comprehensively with reference to drawings. However, the exemplary embodiments can be implemented in various forms and shall not be construed as examples to the described embodiments. On the contrary, the embodiments are provided to make the present application more comprehensive and integral and the concept of the exemplary embodiment is comprehensively transferred to those skilled in the art.

In addition, features, structures or characteristics described herein may be combined in one or more embodiments freely as appropriate. In the description below, many specific details are provided, so that the embodiments of the present application are fully understood. However, those skilled in the art will realize that the technical solution of the present application can be practiced without one or more of specific details or other methods, components, devices, steps and the like can be used. In other cases, known methods, devices, implementations or operations are not illustrated or described in detail to prevent obscuring all aspects of the present application.

The present application will be further described in detail below in combination with the drawings and the specific embodiments. It is to be noted herein that technical features involved in the described embodiments of the present application can be combined with one another as long as they do not conflict with each other. The embodiments described with reference to the drawings below are exemplary, and are merely used for explaining the present application and are not construed as a limitation to the present application.

Embodiment I

The embodiment of the present application provides a memory, which can be a DRAM, for example, a three-dimensional DRAM, i.e., a memory formed by stacking multiple layers of DRAM. But it shall be appreciated that the memory in the embodiment is not limited to DRAM but may also be a memory of another type, which depends on circumstances.

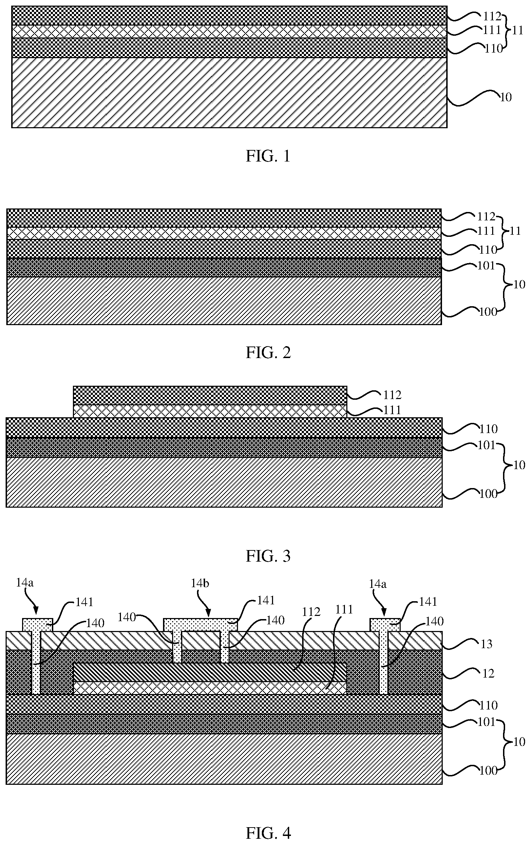

As shown in FIG. 1, the memory in the embodiment may include a substrate 10 and a plurality of storage units formed on the substrate 10, the storage units can include one capacitor 11, and the capacitor 11 is formed on the substrate 10.

The capacitor 11 may include a first electrode layer 110, a dielectric layer 111 and a second electrode layer 112 formed in a stacked manner in sequence on the substrate 10, that is to say, the dielectric layer 111 is formed between the first electrode layer 110 and the second electrode layer 112.

For example, the capacitor 11 may be a Metal-Isolation-Metal (MIM) structure, i.e., the first electrode layer 110 and the second electrode layer 112 each includes a metal or a metal compound and has a conducting property. The dielectric layer 111 is an insulator for isolating the first electrode layer 110 and the second electrode layer 112.

As shown in FIG. 2, the substrate 10 may include a semiconductor base 100, for example, a silicon base, but is not limited thereto. The substrate may also be a base formed by another semiconductor material (for example, silicon carbide, a gallium compound and a germanium compound). In order to isolate influence of the semiconductor base 100 on the MIM structure, the substrate 10 may further include forming an insulation isolation layer 101 between the first electrode layer 110 and the semiconductor base 100, that is to say, prior to forming the first electrode layer 110 on the semiconductor base 100, forming the insulation isolation layer 101 on the semiconductor base 100 first, and then forming the first electrode layer 110 to insulate the semiconductor base 100 and the first electrode layer 110 with the insulation isolation layer 101.

For example, the insulation isolation layer 101 may be a $SiO_2$ (silicon dioxide) material, but is not limited thereto. The insulation isolation layer may also be another insulating material, which depends on circumstances.

To measure the electric property of the dielectric layer 111 in the capacitor 11, in the process of manufacturing the capacitor 11 on the substrate 10, a measurement electrode for measuring the capacitor 11 may also be manufactured, and a specific relation between the capacitor 11 and the measurement electrode is as follows.

As shown in FIG. 3, in the capacitor 11, orthographic projections of the second electrode layer 112 and the dielectric layer 111 on the substrate 10 are fall with a middle area of an orthographic projection of the first electrode layer 110 on the substrate 10, that is to say, an edge area of the first electrode layer 110 is not covered by the second electrode layer 112 and the dielectric layer 111, so that the subsequently manufactured measurement electrode is in contact with the first electrode layer 110 conveniently, where the orthographic projection of the second electrode layer 112 on the first electrode layer 110 is overlapped with the orthographic projection of the dielectric layer 111 on the first electrode layer 110 to guarantee the storage capacity of the capacitor 11.

As shown in FIG. 4, after forming the capacitor 11 on the substrate 10, the memory further includes an insulation dielectric layer 12 formed on the substrate 10, an etch stop layer 13 and a first measurement electrode 14a and a second measurement electrode 14b arranged at intervals.

The insulation dielectric layer 12 covers the edge area of the first electrode layer 110 and the second electrode layer 112, the etch stop layer 13 is formed at a side of the insulation dielectric layer 12 away from the substrate 10, and the etch stop layer 13 fully covers the insulation dielectric layer 12. The first measurement electrode 14a and the second measurement electrode 14b each includes a via hole conduction portion 140 and a measurement conduction portion 141 connected with each other, the measurement conduction portion 141 of the first measurement electrode 14a and the measurement conduction portion of the second measurement electrode 14b are formed at a side of the etch stop layer 13 away from the substrate 10 for being connected to an external measurement device which measures the performance of the capacitor 11.

An orthographic projection of the via hole conduction portion 140 of the first measurement electrode 14a on the substrate 10 fall with an orthographic projection of the edge area of the first electrode layer 110 on the substrate 10, the via hole conduction portion 140 of the first measurement electrode 14a penetrates through the etch stop layer 13 and the insulation dielectric layer 12 in sequence and is in contact with the edge area of the first electrode layer 110, so that one pole of the measurement device is in contact with the first electrode layer 110 through the first measurement electrode 14a; an orthographic projection of the via hole conduction portion 140 of the second measurement electrode 14b on the substrate 10 falls within an orthographic projection of the second electrode layer 112 on the substrate 10, the via hole conduction portion 140 of the second measurement electrode 14b penetrates through the etch stop layer 13 and the insulation dielectric layer 12 in sequence and is in contact with the edge area of the second electrode layer 112, so that the other pole of the measurement device is in contact with the second electrode layer 112 through the first measurement electrode 14b.

In the embodiment, a material of the first measurement electrode 14a and the second measurement electrode 14b may be TiN (titanium nitride) and the like, but is not limited thereto. The material may also be another conducting material, which depends on circumstances.

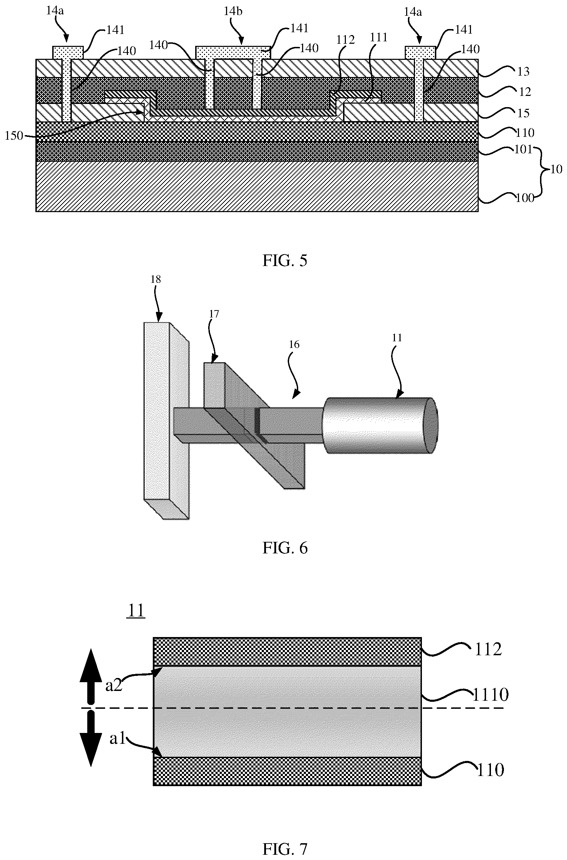

Since the dielectric layer 111 in the capacitor 11 is very thin, usually several nanometers, electric leakage at the edge of the dielectric layer 111 is large. Electric leakage at the edge does not pertain to the intrinsic property of the material, and will interfere with a measured effect. On this basis, as shown in FIG. 5, the memory in the embodiment may further include an interlevel dielectric layer 15 to open the distance between the edge of the second electrode layer 112 and the first electrode layer 110 larger.

Specifically, as shown in FIG. 5, the interlevel dielectric layer 15 may be formed between the first electrode layer 110 and the insulation dielectric layer 12. It shall be appreciated that the via hole conduction portion 140 of the abovementioned first measurement electrode 14a further penetrates through the interlevel dielectric layer 15 to be in contact with the edge area of the first electrode layer 110 while penetrating through the etch stop layer 13 and the insulation dielectric layer 12. Moreover, the interlevel dielectric layer 15 further has a through hole 150 to expose part of the first electrode layer 110.

As shown in FIG. 5, the dielectric layer 111 has a middle portion and an edge portion arranged around the middle portion. The middle portion of the dielectric layer 111 is formed in the through hole 150 and is in contact with the first electrode layer 110. The edge portion of the dielectric layer 111 is in overlap joint to a surface of the interlevel dielectric layer 15 away from the first electrode layer 110 to open the distance between the edge of the second electrode layer 112 and the first electrode layer 110 larger, and the orthographic projection of the via hole conduction portion 140 of the second measurement electrode 14b on the substrate 10 falls within the orthographic projection of the through hole 150 in the substrate 10, that is to say, the orthographic projection of the via hole conduction portion 140 of the second measurement electrode 14b on the substrate 10 falls within an orthographic projection of the middle portion of the dielectric layer 111 on the substrate 10 to accurately measure the K value and electric leakage in the middle of the dielectric layer 111.

For example, as shown in FIGs. 4 and 5, a plurality of via hole conduction portions 140 are arranged in the first measurement electrode 14a and the second measurement electrode 14b and the via hole conduction portions are arranged around an axis of the through hole 150 at an equal interval. Thus, in the measuring process, the electric field is distributed more uniformly, and the measuring effect is more accurate.

It is to be noted that when the plurality of via hole conduction portions 140 are arranged in the first measurement electrode 14a and the second measurement electrode 14b, there may be only one measurement conduction portion 141 in the first measurement electrode 14a and the second measurement electrode 14b, but is not limited thereto. The plurality of measurement conduction portions may be arranged and the measurement conduction portions are arranged around the axis of the through hole 150 at equal intervals. The measurement conduction portions may be in one-to-one correspondence connection to the via hole conduction portions 140 and one measurement conduction portion may correspond to more via hole conduction portions.

The first measurement electrode 14a and the second measurement electrode 14b mentioned in the embodiment are not limited to a finally produced memory. After a test is completed, in a process of cutting dies, they are fully cut or partially cut and the like, which depends on circumstances but does not affect end use of the product.

In the embodiment, in combination with FIG. 6, besides the capacitor 11, the storage unit may further include a transistor 16, a word line 17 and a bit line 18. The transistor 16, the word line 17 and the bit line 18 all may be formed on the substrate 10. The grid electrode of the transistor 16 may be connected to the word line 17, one of source and drain electrodes of the transistor 16 are connected to the bit line 18, and the other one is connected to the capacitor 11; specifically, it may be connected to the first electrode layer 110 of the capacitor 11 to realize a read-write operation of data, that is to say, the storage unit may be of a 1T1C structure.

As far as the memory including the 1T1C (one transistor 16+one capacitor 11) structure is concerned, the capacitor 11 is an important factor which restrains critical size of the memory. How to improve the storage density of the DRAM on the premise of reducing the critical size to guarantee that the DRAM chip has an enough signal resolution becomes a problem needed to be solved urgently.

When the memory is the three-dimensional DRAM, as shown in FIG. 6, the capacitor 11 may be transversely placed, so that the storage density of the capacitor may be effectively increased by reducing the transverse length of the capacitor 11. Besides, the first electrode layer 110, the second electrode layer 112 and the dielectric layer 111 of the capacitor 11 may further be adjusted, so that the capacitor 11 has a higher dielectric constant (K value for short), i.e., the storage density is increased, and the electric leakage is reduced. Besides the three-dimensional DRAM, this mode may further be applicable to memories including a capacitor structure. The structure of the capacitor 11 in embodiments of the present application will be descried in detail below in conjunction with the accompanying drawings.

In the embodiment, as shown in FIG. 7, the dielectric layer 111 of the capacitor may include a strontium titanate dielectric layer 1110 (STO dielectric layer for short), the strontium titanate dielectric layer 1110 including strontium (Sr) and titanium (Ti).

According to research, when the strontium titanate dielectric layer 1110 is integrally designed with high Sr content, i.e., the Sr content in the overall design of the strontium titanate dielectric layer 1110 is greater than the Ti content, the strontium titanate dielectric layer 1110 is a strontium-rich (Sr Rich) layer, the K value will be great and the storage density is high. But the strontium titanate dielectric layer 1110 is easily cracked. Thus, the electric field is not distributed uniformly in the formed capacitor, which results in an electric leakage of the capacitor 11. Moreover, since Sr is a heavy metal which is easy to form an oxygen vacancy, thus the electric leakage is further increased. When the strontium titanate dielectric layer 1110 is integrally designed with high Ti content, i.e., the Ti content in the overall design of the strontium titanate dielectric layer 1110 is greater than the Sr content, the strontium titanate dielectric layer 1110 is a titanium-rich (Ti Rich) layer, the strontium titanate dielectric layer is not easily cracked, and has a low leakage effect. But the K value will be less, which is harmful for size reduction of the capacitor, thereby being further harmful to improving the storage density of the DRAM chip.

Therefore, in the embodiment of the present application, the structure of the strontium titanate dielectric layer 1110 is designed gradiently. Specifically, in the direction from the center of the strontium titanate dielectric layer 1110 to the two opposite sides of the strontium titanate dielectric layer 1110, the ratios of Sr/(Sr+Ti) in the strontium titanate dielectric layer 1110 decrease gradually (i.e., the ratios of the Sr contents in the strontium titanate dielectric layer 1110 decrease gradually and the ratios of the Ti content increase gradually); in other words, in the direction from the two opposite sides of the strontium titanate dielectric layer 1110 to the center of the strontium titanate dielectric layer 1110, the ratios of Sr/(Sr+Ti) in the strontium titanate dielectric layer 1110 increase gradually (i.e., the ratios of the Sr contents in the strontium titanate dielectric layer 1110 increase gradually and the ratios of the Ti content decrease gradually).

One side of the two opposite sides of the abovementioned strontium titanate dielectric layer 1110 is close to the first electrode layer 110 and the other side thereof is close to the second electrode layer 112. In the direction from the center of the strontium titanate dielectric layer 1110 to the first electrode layer 110, the ratios of Sr/(Sr+Ti) in the strontium titanate dielectric layer 1110 decrease gradually, and in the direction from the center of the strontium titanate dielectric layer 1110 to the second electrode layer 112, the ratios of Sr/(Sr+Ti) in the strontium titanate dielectric layer 1110 decrease gradually as well.

In the solution of the embodiment, compared with the technical solution that the strontium titanate dielectric layer 1110 is integrally the titanium rich layer or the strontium rich layer, the ratios of the Sr contents in the strontium titanate dielectric layer 1110 decrease gradually from the center of the strontium titanate dielectric layer 1110 to the direction of the two opposite sides of the strontium titanate dielectric layer 1110 and the ratios of the Ti contents increase gradually from the center of the strontium titanate dielectric layer 1110 to the direction of the two opposite sides of the strontium titanate dielectric layer 1110, so that while the high Sr content in the overall strontium titanate dielectric layer 1110 is guaranteed to have a relatively high K value, the stress of the strontium titanate dielectric layer 1110 can be further favorably released or relaxed as it is easy to crystallize due to the high Sr content, i.e., the stress is gradually released from the center of the strontium titanate dielectric layer 1110 to both sides of the strontium titanate dielectric layer; by reducing the internal stress of the strontium titanate dielectric layer 1110, cracks of the strontium titanate dielectric layer 1110 can be reduced, the surface uniformity of the strontium titanate dielectric layer 1110 is improved, and therefore, it has the low leakage performance.

That is to say, in the solution, the K value of the capacitor 11 is improved, i.e., the electric leakage is reduced while the storage density of the capacitor 11 is effectively improved, which is beneficial to reducing the critical size in the 1T1C structure and improving the storage density of the three-dimensional DRAM.

Exemplarily, the ratio of Sr/(Sr+Ti) at the center of the strontium titanate dielectric layer 1110 is greater than 50%, i.e., the Sr content at the center of the strontium titanate dielectric layer 1110 is greater than the Ti content, the center of the strontium titanate dielectric layer 1110 is in the Sr rich state to guarantee that the center of the strontium titanate dielectric layer 1110 has the relatively high K value, so as to guarantee that the whole strontium titanate dielectric layer 1110 has a good storage density.

It shall be noted that the ratio of Sr/(Sr+Ti) at the center of the strontium titanate dielectric layer 1110 may be related to its thickness to guarantee the overall performance of the strontium titanate dielectric layer 1110.

The thickness of the strontium titanate dielectric layer 1110 may range from 5 nm to 7 nm, for example, 5 nm, 5.5 nm, 6 nm, 7 nm and the like, and the ratio of Sr/(Sr+Ti) at the center of the strontium titanate dielectric layer 1110 ranges from 60% to 65%, for example, 60%, 61%, 62%, 63%, 64%, 65% and the like.

For example, when the thickness of the strontium titanate dielectric layer 1110 is about 6 nm, the ratio of Sr/(Sr+Ti) at the center of the strontium titanate dielectric layer 1110 may substantially reach 62%, so that the capacitor may realize the performance of the high K value (>60) and low electric leakage ($<10^{-5}$).

In an embodiment of the present application, as shown in FIG. 7, the strontium titanate dielectric layer 1110 is of a single-layer structure as a whole, that is to say, when the strontium titanate dielectric layer 1110 is formed at a side of the first electrode layer 110 away from the substrate 10, it may be formed by using a film forming process, for example, a strontium titanate material may be deposited at the side of the first electrode layer 110 away from the substrate 10 through an Atomic layer deposition (ALD) process to form the strontium titanate dielectric layer 1110.

In the atomic layer deposition process, the ratios of Sr contents in the strontium titanate dielectric layer 1110 increase gradually and decrease gradually successively by adjusting the flow of an Sr precursor and/or a Ti precursor, so that the ratios of Sr/(Sr+Ti) in the strontium titanate material increase gradually and decrease gradually successively to form the abovementioned strontium titanate dielectric layer 1110, i.e., in the direction from the two opposite sides of the strontium titanate dielectric layer 1110 to the center of the strontium titanate dielectric layer 1110, the ratios of Sr/(Sr+Ti) in the strontium titanate dielectric layer 1110 increase gradually.

Further, as shown in FIG. 7, in the strontium titanate dielectric layer 1110, a surface close to the first electrode layer 110 is defined as a first boundary surface a1, a surface close to the second electrode layer 112 is defined as a second boundary surface a2, and the content of Sr at the first boundary surface a1 and the second boundary surface a2 may be 0; in other words, when the strontium titanate dielectric layer 1110 is manufactured, the initial strontium titanate material deposited in the primary atomic layer deposition process does not contain Sr or the Sr content is very small and is approximately 0; then the Sr ratio in the strontium titanate material is increased gradually; when it reaches a set quantity, the Sr ratio in the strontium titanate material is decreased gradually, so that the Sr content in the strontium titanate material when the primary atomic layer deposition process is finished is 0 or is approximately 0.

It shall be appreciated that when the content of Sr at the first boundary surface a1 and the second boundary surface a2 in the strontium titanate dielectric layer 1110 is 0, the first boundary surface a1 and the second boundary surface a2 may be construed as titanium dioxide ($TiO_2$) surfaces, and $TiO_2$ used at the boundary surfaces may effectively reduce the oxygen vacancies in the strontium titanate dielectric layer 1110, so that electric leakage is reduced.

For example, when the strontium titanate dielectric layer 1110 of the single-layer structure is manufactured, in addition to containing Sr, the strontium titanate may further be doped with aluminum (Al) when the primary atomic layer deposition process is started and finished, that is to say, the first boundary surface a1 and the second boundary surface a2 may be aluminum titanate (ATO) boundary surfaces to improve the conduction band offset (CBO), so as to further reduce electric leakage.

It shall be appreciated that when a semiconductor and a semiconductor or an insulator and a semiconductor are in contact to form an interfacial structure, due to different energy gap widths, discontinuous offsets will be formed at the bottom of a conduction band and at the top of a valence band of materials on both sides, i.e., band offset. The band offset at the bottom of the conduction band is called a conduction band offset (CBO) and the band offset at the top of the valence band is called a valence band offset (VBO).

In an optional embodiment, in the direction from the center (the center passes through the dotted line in FIG. 7) of the strontium titanate dielectric layer 1110 to the two opposite sides of the strontium titanate dielectric layer 1110 (the direction shown by a black bold arrow in FIG. 7), the ratios of Sr/(Sr+Ti) in the strontium titanate dielectric layer 1110 decrease gradually according to a linear relation, and in other words, in the direction from the center of the strontium titanate dielectric layer 1110 to the two opposite sides of the strontium titanate dielectric layer 1110, the ratios of Sr/(Sr+Ti) in the strontium titanate dielectric layer 1110 may decrease at a constant speed to better balance the performance of the strontium titanate dielectric layer 1110 with high K value and low electric leakage.

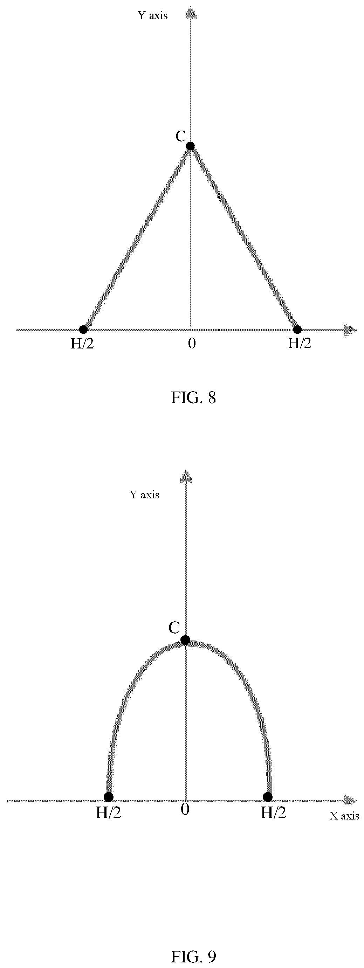

Exemplarily, as shown in FIG. 8, the abovementioned linear relation may specifically be:

$$\frac{Sr}{Sr+Ti} = C - \frac{2C \times D}{H} \qquad \text{Equation (1)},$$

C is a ratio of Sr/(Sr+Ti) at the center of the strontium titanate dielectric layer 1110, D is a distance deviated from the center of the strontium titanate dielectric layer 1110, H is a thickness of the strontium titanate dielectric layer 1110, and $0 \leq D \leq H/2$.

For example, when C is 0.62 and H is 6 nm, the linear relation may be:

$$\frac{Sr}{Sr+Ti} = 0.62 - \frac{0.62 \times D}{3},$$

when the distance deviated from the center of the strontium titanate dielectric layer 1110 in the direction close to the first electrode layer 110 is 3 nm, the ratio of Sr/(Sr+Ti) is 0, which may be construed as the abovementioned first boundary surface a1; and when the distance deviated from the center of the strontium titanate dielectric layer 1110 in the direction close to the second electrode layer 112 is 3 nm, the ratio of Sr/(Sr+Ti) is 0, which may be construed as the abovementioned second boundary surface a2.

In another optional embodiment, as shown in FIG. 9, in the direction from the center of the strontium titanate dielectric layer 1110 to the two opposite sides of the strontium titanate dielectric layer 1110, the decreasing rates of the ratios of Sr/(Sr+Ti) in the strontium titanate dielectric layer 1110 increase gradually, and in other words, in the direction from the two opposite sides of the strontium titanate dielectric layer 1110 to the center of the strontium titanate dielectric layer 1110, the increasing rates of the ratios of Sr/(Sr+Ti) in the strontium titanate dielectric layer 1110 decrease gradually, that is to say, when the whole strontium titanate dielectric layer 1110 is manufactured, the K value of the strontium titanate dielectric layer 1110 may further be improved while guaranteeing the strontium titanate dielectric layer 1110 has the performance of low electric leakage by rapidly increasing the Sr content first, then slowly increasing the Sr content to the maximum value, and then slowly decreasing the Sr content and rapidly decreasing the Sr content.

Exemplarily, the ratios of Sr/(Sr+Ti) in the strontium titanate dielectric layer 1110 meet the following relational expression:

$$\frac{Sr}{Sr+Ti} = C \times \cos \left( \frac{\pi \times D}{H} \right) \qquad \text{Equation (2)},$$

C is the ratio of Sr/(Sr+Ti) at the center of the strontium titanate dielectric layer 1110, D is a distance deviated from the center of the strontium titanate dielectric layer 1110, H is a thickness of the strontium titanate dielectric layer 1110, and $0 \leq D \leq H/2$.

For example, when C is 0.62 and H is 6 nm, the relational expression met by the ratios of Sr/(Sr+Ti) in the strontium titanate dielectric layer 1110 may be:

$$\frac{Sr}{Sr+Ti} = 0.62 \times \cos \left( \frac{\pi D}{6} \right),$$

when the distance deviated from the center of the strontium titanate dielectric layer 1110 in the direction close to the first electrode layer 110 is 3 nm, the ratio of Sr/(Sr+Ti) is 0, which may be construed as the abovementioned first boundary surface a1; and when the distance deviated from the center of the strontium titanate dielectric layer 1110 in the direction close to the second electrode layer 112 is 3 nm, the ratio of Sr/(Sr+Ti) is 0, which may be construed as the abovementioned second boundary surface a2.

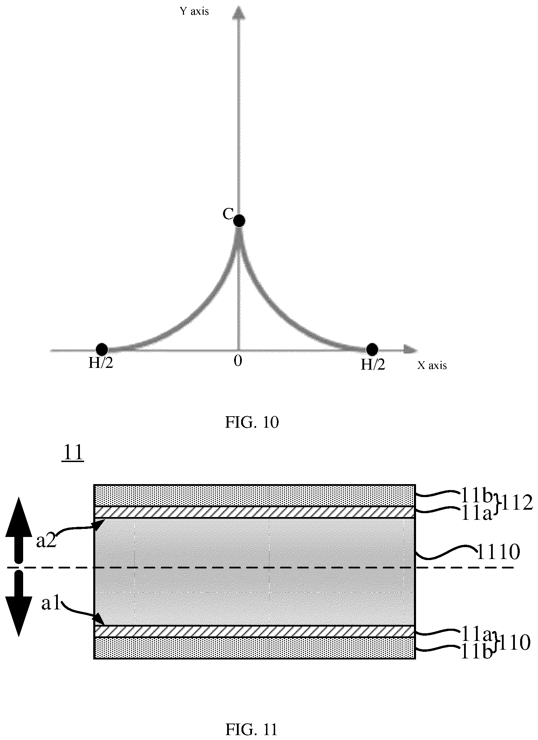

In yet another optional embodiment, as shown in FIG. 10, in the direction from the center of the strontium titanate dielectric layer 1110 to the two opposite sides of the strontium titanate dielectric layer 1110, the decreasing rates of the ratios of Sr/(Sr+Ti) in the strontium titanate dielectric layer 1110 decrease gradually, and in other words, in the direction from the two opposite sides of the strontium titanate dielectric layer 1110 to the center of the strontium titanate dielectric layer 1110, the increasing rates of the ratios of Sr/(Sr+Ti) in the strontium titanate dielectric layer 1110 increase gradually, that is to say, when the whole strontium titanate dielectric layer 1110 is manufactured, the surface uniformity of the two opposite sides of the strontium titanate dielectric layer 1110 may further be improved while guaranteeing the strontium titanate dielectric layer 1110 has the K value by slowly increasing the Sr content first, then rapidly increasing the Sr content to the maximum value, and then rapidly decreasing the Sr content and slowly decreasing the Sr content, so that the strontium titanate dielectric layer has the performance of low electric leakage.

It shall be appreciated that the X axis in FIGs. 8-10 is used to represent the distance deviated from the strontium titanate dielectric layer 1110, with the unit of nm (nanometer), the Y axis is used to represent the ratio of Sr/(Sr+Ti), the line on the left side of the Y axis is used to represent the ratio change of Sr/(Sr+Ti) between the center of the strontium titanate dielectric layer 1110 and the first electrode layer 110, and the line on the right side of the Y axis is used to represent the ratio change of Sr/(Sr+Ti) between the center of the strontium titanate dielectric layer 1110 and the second electrode layer 112.

Besides, in order to further improve the performance of the capacitor, as shown in FIG. 11, the first electrode layer 110 and the second electrode layer 112 in the embodiment each may include a ruthenium element film layer 11a, the ruthenium element film layer 11a is a metal ruthenium (Ru) film layer or a ruthenium oxide ($RuO_2$) film layer with a high work function, where the work function is also called a work function and escape work, which is defined in solid physics as follows: least energy needed to just move an electron from the inside of a solid to the surface of the object.

For example, the dielectric layer 111 of the capacitor may only include the abovementioned strontium titanate dielectric layer 1110, and the first boundary surface a1 of the strontium titanate dielectric layer 1110 may be in contact with the ruthenium element film layer 11a of the first electrode layer 110, the second boundary surface a2 of the strontium titanate dielectric layer 1110 may be in contact with the ruthenium element film layer 11a of the second electrode layer 112, and when the first boundary surface a1 and the second boundary surface a2 of the strontium titanate dielectric layer 1110 are defined as the $TiO_2$ surfaces, the ruthenium element film layer 11a may promote formation of a rutile structure by $TiO_2$ at the boundary surfaces, thereby improving the K value while reducing the electric leakage. Therefore, the K value of the strontium titanate dielectric layer 1110 decreases first and then increases from the middle to both sides, the dielectric constant is mainly improved in the middle and at boundaries, and the area between the middle and the boundaries mainly plays a role in reducing the electric leakage.

As shown in FIG. 11, the first electrode layer 110 and the second electrode layer 112 each further include a titanium nitride film layer 11b, and the titanium nitride film layer 11b is formed at a side of the ruthenium element film layer 11a away from the strontium titanate dielectric layer 1110, so that the thickness of the ruthenium element film layer 11a may be properly reduced by arranging the titanium nitride film layer 11b while guaranteeing that the overall thickness and work functions of the first electrode layer 110 and the second electrode layer 112 meet the requirements. Therefore, the cost of the first electrode layer 110 and the second electrode layer 112 is properly reduced while $TiO_2$ at the boundary surfaces may be promoted to form the rutile structure to reduce the electric leakage and improve the K value.

Embodiment II

Compared with Embodiment I, the main difference between the embodiment in the present disclosure and Embodiment I lies in that the strontium titanate dielectric layer 1110 in the capacitor in Embodiment I is designed in the single-layer structure, and the strontium titanate dielectric layer 1110 in the capacitor in Embodiment II may be of a multilayer stack structure.

The structure of the capacitor in Embodiment of the present application will be descried in detail below in conjunction with the accompanying drawings.

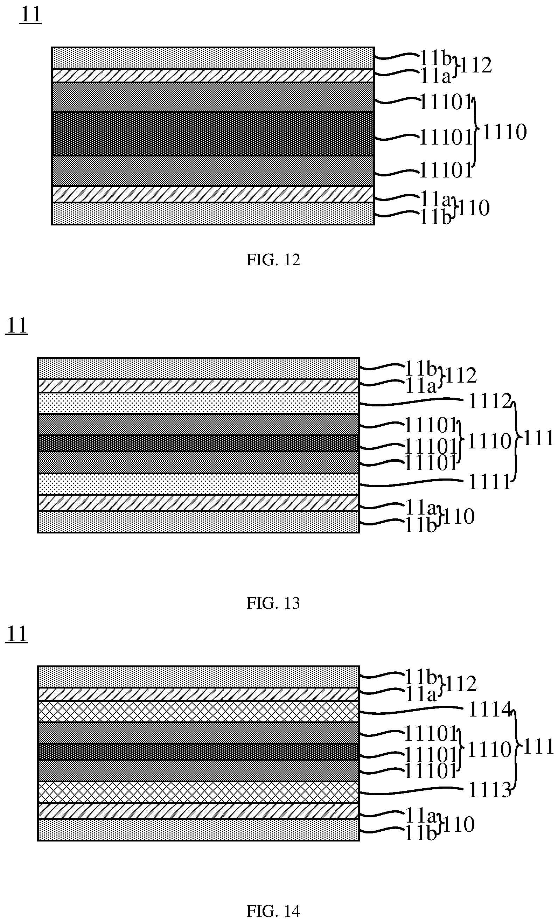

In the embodiment, as shown in FIG. 12, the strontium titanate dielectric layer 1110 may be of the multilayer stack structure and the strontium titanate dielectric layer 1110 may include N strontium titanate film layers 11101 stacked in sequence, N being a positive integer greater than or equal to 3; it shall be appreciated that a film layer is formed by each forming process, that is to say, the strontium titanate dielectric layer 1110 is formed by using multiple forming processes. For example, the step of forming the strontium titanate dielectric layer 1110 at the side of the first electrode layer 110 away from the substrate 10 may specifically include: N strontium titanate film layers 11101 stacked in sequence are formed at the side of the first electrode layer 110 away from the substrate 10 through the N atomic layer deposition processes to form the stacked strontium titanate dielectric layer 1110.

It shall be noted that the strontium titanate film layer 11101 in the embodiment is a film layer containing not only Sr, but also Ti, that is to say, the ratios of Sr/(Sr+Ti) in each strontium titanate film layer 11101 are greater than 0.

In the direction from the center of the strontium titanate dielectric layer 1110 to the two opposite sides of the strontium titanate dielectric layer 1110, the ratios of Sr/(Sr+Ti) in the strontium titanate dielectric layer 1110 decrease layer by layer. As shown in FIG. 12, taking N=3 as an example for description, the strontium titanate dielectric layer 1110 may include the first strontium titanate film layers 11101, the second strontium titanate film layers 11101 and the third strontium titanate film layers 11101 stacked in sequence, where the ratios of Sr/(Sr+Ti) in the second strontium titanate film layers 11101 are the greatest, and the ratios of Sr/(Sr+Ti) in the first strontium titanate film layers 11101 and the third strontium titanate film layers 11101 are less than the ratios of Sr/(Sr+Ti) in the second strontium titanate film layers 11101. It shall be noted that the strontium titanate dielectric layer 1110 is not limited to include the three strontium titanate film layers 11101 shown in FIG. 12, and further includes 4, 5 layers and the like, which depends on circumstances.

In the embodiment, the strontium titanate dielectric layer 1110 is designed as the multilayer stack structure, so that the manufacturing mode is simple while the gradient design of the strontium titanate dielectric layers 1110 is realized to guarantee that the strontium titanate dielectric layers 1110 has the characteristics of high K value and low electric leakage. Furthermore, while it is guaranteed that the thickness of the strontium titanate dielectric layers 1110 is unchanged, the thickness of each layer is less through layered manufacturing, so that the film forming uniformity is easily controlled, and thus, the product performance is improved. Moreover, it is beneficial for the product to come into use rapidly. The strontium titanate film layers 11101 may be formed in sequence by using known equipment without researching and developing the equipment again, so that the research and development costs are reduced.

Besides, in the embodiment, the strontium titanate dielectric layer 1110 is designed being formed by stacking at least three strontium titanate film layers 11101, so that the gradient design of the area of the strontium titanate dielectric layer 1110 to the first electrode layer 110 and the area of the strontium titanate dielectric layer close to the second electrode layer 112 is realized, guaranteeing the characteristics of high K value and low electric leakage between the strontium titanate dielectric layer 1110 and the first electrode layer 110 and between the strontium titanate dielectric layer and the second electrode layer 112.

Exemplarily, N in the embodiment may be an odd number greater than or equal to 3, that is to say, the quantity of the strontium titanate film layers 11101 in the strontium titanate dielectric layer 1110 is an odd number which is greater than or equal to 3, for example, N=3, 5, 7, 9 and the like, which depends on circumstances.

In the embodiment, the quantity of the strontium titanate film layers 11101 in the strontium titanate dielectric layer 1110 is designed as the odd number, so that it is guaranteed that the quantities of the film layers on the two opposite sides of the strontium titanate film layer 11101 in the middle are same to guarantee the balanced gradient design in the area of the strontium titanate dielectric layer 1110 to the first electrode layer 110 and the area of the strontium titanate dielectric layer close to the second electrode layer 112, thereby improving the product quality.

The ratios of Sr/(Sr+Ti) in all parts of the strontium titanate film layers 11101 may be equal, that is to say, in each atomic layer deposition process, the constants of the Sr precursor and the Ti precursor are constantly unchanged, so that the strontium titanate film layers 11101 may be formed in sequence by using the known equipment without researching and developing the equipment again, thereby reducing the research and development costs.

It shall be appreciated that the ratios of Sr/(Sr+Ti) among the strontium titanate film layers 11101 in the strontium titanate dielectric layer 1110 may be designed according to the equations (1) and (2) mentioned in Embodiment I, where in Embodiment II, the parameter C mentioned in the equations (1) and (2) is the ratio of Sr/(Sr+Ti) in the middlemost strontium titanate film layer 11101 and the parameter D is the distance from the center of another film layer deviated from the center of the middlemost strontium titanate film layer 11101.

In an optional embodiment, as shown in FIG. 13, besides the abovementioned strontium titanate dielectric layer 1110, the dielectric layer 111 of the capacitor 11 may further include a first titanium oxide dielectric layer 1111 and a second titanium oxide dielectric layer 1112, the first titanium oxide dielectric layer 1111 being formed between the first electrode layer 110 and the strontium titanate film layer 11101 of the strontium titanate dielectric layer 1110 and the second titanium oxide dielectric layer 1112 being formed between the second electrode layer 112 and the strontium titanate dielectric layer 1110. By forming the first titanium oxide dielectric layer 1111 and the second titanium oxide dielectric layer 1112 at the two opposite sides of the strontium titanate dielectric layer 1110, the gradient design of the dielectric layer 111 is further realized, i.e., compared with the middle strontium titanate film layer 11101, the film layers located at the two outermost sides of the dielectric layer 111 do not contain Sr to be formed as the first titanium oxide dielectric layer 1111 and the second titanium oxide dielectric layer 1112. Therefore, the uniformity of the surfaces of the two outermost sides of the dielectric layer 111 as a whole in the capacitor 11 may be guaranteed, so that the capacitor has the performance of low electric leakage.

Besides, when the first electrode layer 110 and the second electrode layer 112 in the embodiment each include the ruthenium element film layer 11a mentioned in the above embodiment, the first titanium oxide dielectric layer 1111 may be in contact with the ruthenium element film layer 11a of the first electrode layer 110, and the second titanium oxide dielectric layer 1112 may be in contact with the ruthenium element film layer 11a of the second electrode layer 112. The ruthenium element film layer 11a may promote the first titanium oxide dielectric layer 1111 and the second titanium oxide dielectric layer 1112 to be in contact with the ruthenium element film layer to form the rutile structure, so that the K value is improved while electric leakage is reduced. Therefore, the K value in the whole dielectric layer 111 decreases first and then increases from the middle to both sides in the first electrode layer 110 and the second electrode layer 112. The dielectric constant is mainly improved in the middle and at boundaries, and the area between the middle and the boundaries mainly plays a role in reducing the electric leakage.

In another optional embodiment, as shown in FIG. 14, besides the abovementioned strontium titanate dielectric layer 1110, the dielectric layer 111 of the capacitor 11 may further include a first aluminum titanate dielectric layer 1113 and a second aluminum titanate dielectric layer 1114, the first aluminum titanate dielectric layer 1113 being formed between the first electrode layer 110 and the strontium titanate dielectric layer 1110 and the second aluminum titanate dielectric layer 1114 being formed between the second electrode layer 112 and the strontium titanate dielectric layer 1110.

For example, the first aluminum titanate dielectric layer 1113 may be in contact with the ruthenium element film layer 11a of the first electrode layer 110 and the second aluminum titanate dielectric layer 1114 may be in contact with the ruthenium element film layer 11a of the second electrode layer 112. Therefore, in such a design, the conduction band offset (CBO) may be improved while improving the K value, so that the electric leakage is further reduced.

It shall be noted that except for the above difference with Embodiment I, other designs in Embodiment II may refer to the content in Embodiment I, which are not repeatedly described here.

Embodiment **III**

The embodiment of the present application further provides a manufacturing method of a memory, which may manufacture the memory provided in the above embodiments, and detailed description about the memory may refer to the above embodiments, which is not repeatedly described here.

In conjunction with FIGs. 1 to 25, the manufacturing method of the memory may at least include step S100, step S200, step S300 and step S400.

In step S100, a substrate 10 is provided. For example, a semiconductor base 100 may be provided first, and then an insulation isolation layer 101 is formed on the semiconductor base 100, as shown in FIGs. 2-5. The semiconductor base 100 may be a silicon substrate, the insulation isolation layer 101 may be $SiO_2$, and the deposition thickness of the insulation isolation layer 101 may be 2000 Å (angstrom).

In step S200, a first electrode 110 is formed on the substrate 10. For example, the first electrode layer 110 may be formed at a side of the insulation isolation layer 101 away from the semiconductor base 100, where the first electrode layer 110 may include a TiN layer and a $RuO_2$ layer formed at the side of the insulation isolation layer 101 away from the semiconductor base 100 in sequence.

In step S300, a dielectric layer 111 is formed at a side of the first electrode layer 110 away from the substrate 10, and the dielectric layer 111 at least includes a strontium titanate dielectric layer 1110. In a direction from a center of the strontium titanate dielectric layer 1110 to two opposite sides of the strontium titanate dielectric layer 1110, the ratios of Sr/(Sr+Ti) in the strontium titanate dielectric layer 1110 decrease gradually. For example, the strontium titanate dielectric layer 1110 may be formed at a side of the $RuO_2$ layer away from the semiconductor base 100.

In an optional embodiment, step S300 specifically includes: depositing a strontium titanate material at a side of the first electrode layer 110 away from the substrate 10 through a primary atomic layer deposition process to form the strontium titanate dielectric layer 1110, as shown in FIG. 7; in the primary atomic layer deposition process, the ratios of Sr/(Sr+Ti) in the strontium titanate material increasing gradually and decreasing gradually successively according to a set rule by adjusting the flow of an Sr precursor and/or a Ti precursor.

In another optional embodiment, step S300 specifically includes: forming N strontium titanate film layers 11101 stacked in sequence at the side of the first electrode layer 110 away from the substrate 10 through N atomic layer deposition processes to form the strontium titanate dielectric layer 1110, N being a positive integer greater than or equal to 3, as shown in FIGs. 12-14; in each atomic layer deposition process, the flows of the Sr precursor and the Ti precursor may be constantly unchanged substantially, i.e., within an error range.

In step S400, a second electrode layer 112 is formed at a side of the strontium titanate dielectric layer 1110 away from the first electrode layer 110 to form a capacitor. The second electrode layer 112 may include a $RuO_2$ layer and a TiN layer formed at a side of the strontium titanate dielectric layer 1110 away from the first electrode layer 110 in sequence.

In an optional embodiment, before step S300 and after step S200, the manufacturing method further includes: forming a first titanium oxide dielectric layer 1111 at a side of the first electrode layer 110 away from the substrate 10; and after step S300 and before step S400, the manufacturing method further includes: forming a second titanium oxide dielectric layer 1112 at a side of the strontium titanate dielectric layer 1110 away from the first electrode layer 110, as shown in FIG. 13.

In another optional embodiment, before step S300 and after step S200, the manufacturing method further includes: forming a first aluminum titanate dielectric layer 1113 at a side of the first electrode layer 110 away from the substrate 10; and after step S300 and before step S400, the manufacturing method further includes: forming a second aluminum titanate dielectric layer 1114 at a side of the strontium titanate dielectric layer 1110 away from the first electrode layer 110, as shown in FIG. 14.

The step of forming a first aluminum titanate dielectric layer 1113 at a side of the first electrode layer 110 away from the substrate 10 may specifically include: forming the first titanium oxide dielectric layer 1111 at the side of the first electrode layer 110 away from the substrate 10, and doping an aluminum element into the first titanium oxide dielectric layer 1111 to form the first aluminum titanate dielectric layer 1113; and the step of forming a second aluminum titanate dielectric layer 1114 at a side of the strontium titanate dielectric layer 1110 away from the first electrode layer 110 includes: forming the second titanium oxide dielectric layer 1112 at the side of the strontium titanate dielectric layer 1110 away from the first electrode layer 110, and then doping the aluminum element into the second titanium oxide dielectric layer 1112 to form the second aluminum titanate dielectric layer 1114.

It shall be appreciated that the aluminum element may be doped at the boundary surface of the first titanium oxide dielectric layer 1111 toward the first electrode layer 110 to form the first aluminum titanate dielectric layer 1113 and certain space may also be expanded inward. Similarly, the aluminum element may also be doped at the boundary surface of the second titanium oxide dielectric layer 1112 toward the second electrode layer 112 to form the second aluminum titanate dielectric layer 1114, and certain space may also be expanded inward.

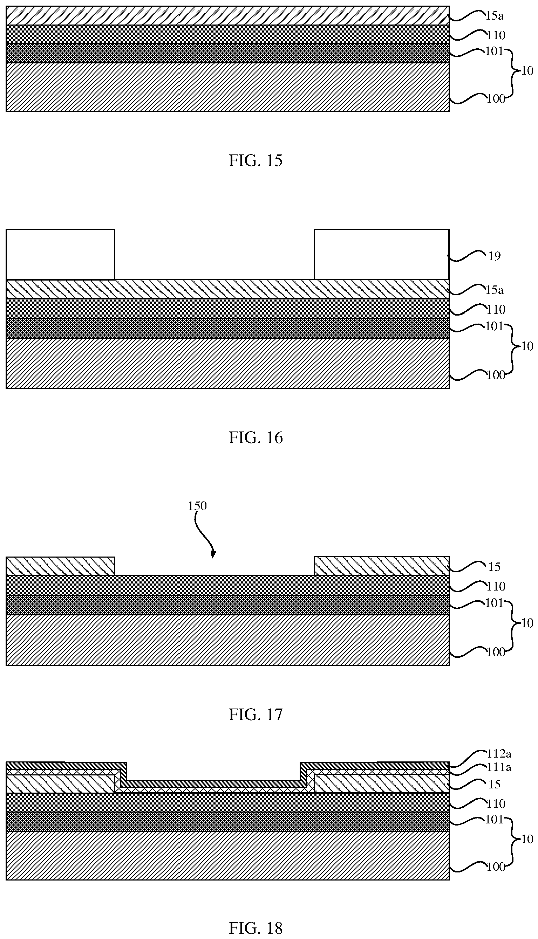

Before step S300 and after step S200, the manufacturing method further includes: forming an interlevel dielectric material film 15a at a side of the first electrode layer 110 away from the substrate 10, as shown in FIG. 15; and forming a through hole 150 through which part of the first electrode layer 110 is exposed in the interlevel dielectric material film 15a through a patterning treatment process to form an interlevel dielectric layer 15.

For example, a photoresist layer may first be formed at a side of the interlevel material film 15a away from the first electrode layer 110, and then the photoresist layer is subjected to exposure and development to form a first photoresist mask layer 19, as shown in FIG. 16; then, the interlevel material film 15a is etched with the first photoresist mask layer 19 to form the through hole 150, and finally, the first photoresist mask layer 19 is removed, as shown in FIG. 17.

It shall be appreciated that at least part of the strontium titanate dielectric layer 1110 is located in the through hole 150 and is in contact with the first electrode layer 110.

The step of forming the strontium titanate dielectric layer 1110 and the second electrode layer 112 at the side of the first electrode layer 110 away from the substrate 10 may specifically include:

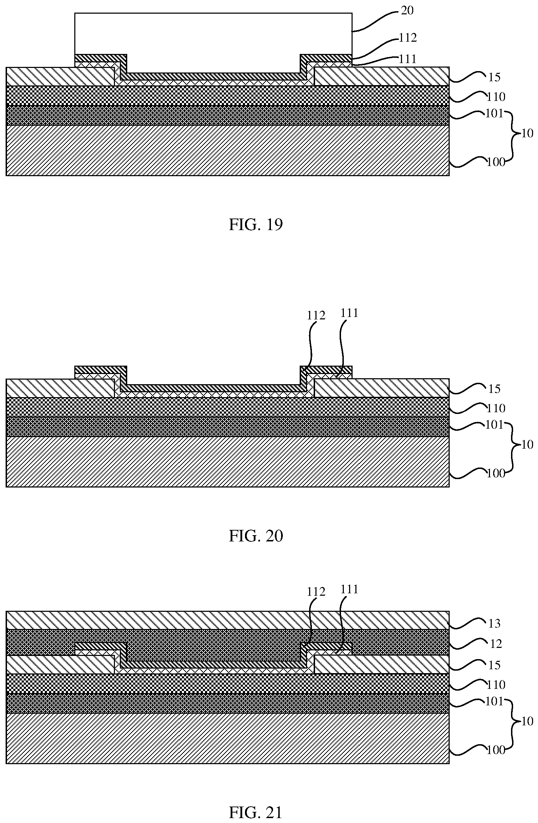

After forming the interlevel dielectric layer 15, forming a dielectric material film (the strontium titanate dielectric material film) 111a and a second electrode material film 112a located in the through hole 150 and covering the interlevel dielectric layer 15 in sequence, as shown in FIG. 18; and then removing the part of the dielectric material film (the strontium titanate dielectric material film) 111a and the second electrode material film 112a covering the interlevel dielectric layer 15 to form the strontium titanate dielectric layer 1110 and the second electrode layer 112, as shown in FIG. 20.

For example, the photoresist layer may first be formed on the second electrode material film 112 and is subjected to exposure and development to form a second photoresist mask layer 20. Then, the dielectric material film (the strontium titanate dielectric material film) 111a and the second electrode material film 112a are etched with the second photoresist mask layer 20 to remove the part of the dielectric material film (the strontium titanate dielectric material film) 111a and the second electrode material film 112a covering the interlevel dielectric layer 15 to form the strontium titanate dielectric layer 1110 and the second electrode layer 112, as shown in FIG. 19. Finally, the second photoresist mask layer 20 is removed, as shown in FIG. 20.

After step S400, the manufacturing method further includes step S500, step S600, step S700 and step S800.

In step S500, an insulation dielectric layer 12 and an etch stop layer 13 are formed in sequence at the sides of the interlevel dielectric layer 15 and the second electrode layer 112 away from the substrate 10, as shown in FIG. 21. For example, a material of the insulation dielectric layer 12 may be $SiO_2$, a material of the etch stop layer 13 may be SiN, which is not limited thereto. The materials of the insulation dielectric layer 12 and the etch stop layer 13 may also be selected according to the actual condition.

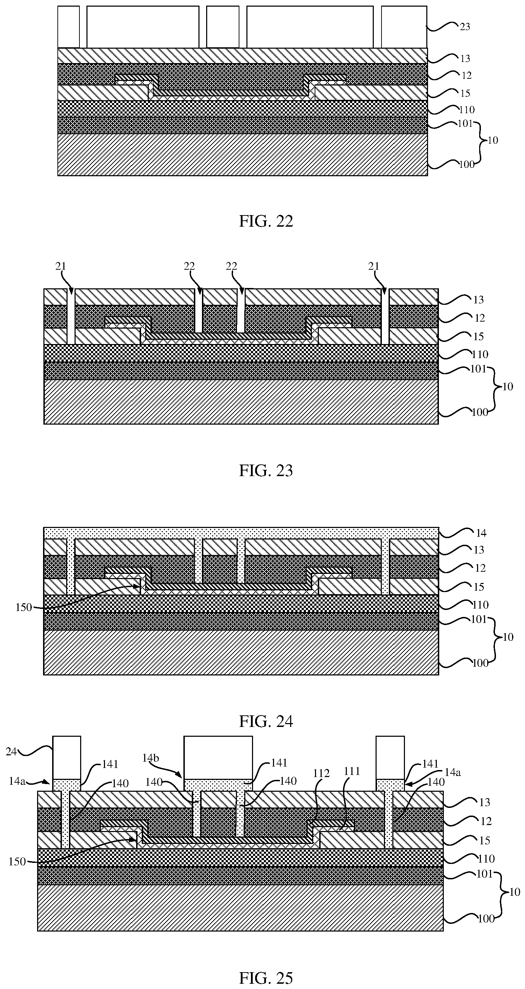

In step S600, a first via hole 21 and a second via hole 22 are formed at an interval, as shown in FIG. 23. An orthographic projection of the first via hole 21 in the substrate 10 falls within an orthographic projection of an edge area of the first electrode layer 110 on the substrate 10, and does not overlap with orthographic projections of the second electrode layer 112 and the strontium titanate dielectric layer 1110 on the substrate 10, the first via hole 21 penetrates through the insulation dielectric layer 12, the etch stop layer 13 and the interlevel dielectric layer 15 in sequence and part of the first electrode layer 110 is exposed, an orthographic projection of the second via hole 22 in the substrate 10 falls within an orthographic projection of the through hole 150 in the substrate 10, the second via hole 22 penetrates through the insulation dielectric layer 12 and the etch stop layer 13 in sequence, and part of the second electrode layer 112 is exposed.

For example, a photoresist layer may first be formed at a side of the etch stop layer 13 away from the insulation dielectric layer 12, and then the photoresist layer is subjected to exposure and development to form a third photoresist mask layer 23, as shown in FIG. 22; then, the photoresist layer is etched with the third photoresist mask layer 23 to form the first via hole 21 and the second via hole 22, and finally, the third photoresist mask layer 23 is removed, as shown in FIG. 23.

In step S700, a measurement electrode material film 14 is formed. The measurement electrode material film 14 cover a surface of the etch stop layer 13 away from the insulation dielectric layer 12 and fills the first via hole 21 and the second via hole 22, as shown in FIG. 24. For example, a material of the measurement electrode material film 14 may be TiN, but is not limited thereto. It may also be other conducting materials.

In step S800, patterning treatment on the measurement electrode material film 14 to form a first measurement electrode 14a and a second measurement electrode 1 4b, where the first measurement electrode 14a and the second measurement electrode 14b each include a via hole conduction portion 140 and a measurement conduction portion 141, the measurement conduction portion 141 of the first measurement electrode 14a and the measurement conduction portion of the second measurement electrode 14b are arranged at intervals and are both formed at the side of the etch stop layer 13 away from the substrate 10, the measurement conduction portion 141 of the first measurement electrode 14a is a measurement electrode material film 14 filling the first via hole 21, and the measurement conduction portion 141 of the second measurement electrode 14b is a measurement electrode material film 14 filling the second via hole 22, as shown in FIG. 5.

For example, a photoresist layer may first be formed at a side of the measurement electrode material film 14 away from the etch stop layer 13, and then the photoresist layer is subjected to exposure and development to form a fourth photoresist mask layer 24; then, the measurement electrode material film 14 on the surface of the etch stop layer 13 is etched with the fourth photoresist mask layer 24, as shown in FIG. 25, to form the measurement conduction portion 141 of the first measurement electrode 14a and the second measurement electrode 14b, and finally, the fourth photoresist mask layer 24 is removed, as shown in FIG. 25.

After the first measurement electrode 14a and the second measurement electrode 14b are formed, an external measuring device is connected to the first measurement electrode 14a and the second measurement electrode 14b to measure the performance of the capacitor.

It shall be appreciated that after the performance of the capacitor is tested with the first measurement electrode 14a and the second measurement electrode 14b, the first measurement electrode 14a and the second measurement electrode 14b may either be cut during die cutting or be reserved on the substrate 10, which depends on circumstances.

In addition, the terms "first", "second", "third" and the like are only used for a description purpose rather than being construed to indicate or imply relative importance or implicitly indicate the quantity of indicated technical features. Thus, features defining "first", "second" and "third" may expressively or implicitly include one or more features. In the description of the present application, "a plurality of" means two or more, unless expressly specified otherwise.

In the description of the specification, the description with reference to the terms "some embodiments", "exemplarily", and the like means that specific features, structures, materials, or features described in connection with the embodiments or examples are included in at least one embodiment or example of the present application. In the description, schematic expressions of the terms do not have to mean same embodiments or exemplary embodiments. Furthermore, specific features, structures, materials or characteristics described may be combined in any one or more embodiments or exemplary embodiments in proper manners. In addition, under a condition without mutual contradiction, those skilled in the art may integrate or combine different embodiments or exemplary embodiments with different embodiments or exemplary embodiments described in the description.

Although the embodiments of the present application have been shown and described above, it may be appreciated that the embodiments are exemplary and cannot be construed as a limitation to the present application. Those of ordinary skill in the art can make changes, modification, replacement and transformation on the embodiments within the scope of the present application. Changes and modifications made according to claims and description of the present application shall fall into the scope of the present application.

**Claims**

1. A capacitor, **characterized by** comprising:

    a first electrode layer;
    a second electrode layer; and
    a strontium titanate dielectric layer, formed between the first electrode layer and the second electrode layer;
    wherein in a direction from a center of the strontium titanate dielectric layer to two opposite sides of the strontium titanate dielectric layer, ratios of Sr/(Sr+Ti) in the strontium titanate dielectric layer decrease gradually;
    one side of the two opposite sides in the strontium titanate dielectric layer is close to the first electrode layer and the other side of the two opposite sides in the strontium titanate dielectric layer is close to the second electrode layer.

2. The capacitor according to claim 1, wherein the strontium titanate dielectric layer is of a single-layer structure.

3. The capacitor according to claim 2, wherein
in the strontium titanate dielectric layer, a surface close to the first electrode layer is defined as a first boundary surface, a surface close to the second electrode layer is defined as a second boundary surface, and a content of Sr at the first boundary surface and the second boundary surface is 0.

4. The capacitor according to claim 1, wherein

the strontium titanate dielectric layer is of a multilayer stacked structure and comprises N strontium titanate film layersstacked in sequence, N is a positive integer greater than or equal to 3; and
in the direction from the center of the strontium titanate dielectric layer to the two opposite sides of the strontium titanate dielectric layer, the ratios of Sr/(Sr+Ti) in the strontium titanate dielectric layer decrease layer by layer.

5. The capacitor according to claim 4, wherein
the ratios of Sr/(Sr+Ti) at everywhere of the strontium titanate dielectric layer are equal.

6. The capacitor according to claim 1, wherein
in the direction from the center of the strontium titanate dielectric layer to the two opposite sides of the strontium titanate dielectric layer, the ratios of Sr/(Sr+Ti) in the strontium titanate dielectric layer decrease gradually according to a linear relation.

7. The capacitor according to claim 6, wherein the linear relation is specifically as follows:

$$\frac{Sr}{Sr+Ti} = C - \frac{2C \times D}{H},$$

wherein C is a ratio of Sr/(Sr+Ti) at the center of the strontium titanate dielectric layer, D is a distance deviated from the center of the strontium titanate dielectric layer in the strontium titanate dielectric layer, H is a thickness of the strontium titanate dielectric layer, and $0 \leq D \leq H/2$.

8. The capacitor according to claim 1, wherein
in the direction from the center of the strontium titanate dielectric layer to the two opposite sides of the strontium titanate dielectric layer, decreasing rates of the ratios of Sr/(Sr+Ti) in the strontium titanate dielectric layer increase gradually.

9. The capacitor according to claim 8, wherein the ratios of Sr/(Sr+Ti) in the strontium titanate dielectric layer meet the following relational expression:

$$\frac{Sr}{Sr+Ti} = C \times \cos \left( \frac{\pi \times D}{H} \right),$$

wherein C is the ratio of Sr/(Sr+Ti) at the center of the strontium titanate dielectric layer, D is a distance deviated from the center of the strontium titanate dielectric layer, H is the thickness of the strontium titanate dielectric layer, and $0 \leq D \leq H/2$.

10. The capacitor according to claim 1, wherein
in the direction from the center of the strontium titanate dielectric layer to two opposite sides of the strontium titanate dielectric layer, decreasing rates of the ratios of Sr/(Sr+Ti) in the strontium titanate dielectric layer decrease gradually.

11. The capacitor according to claim 1, wherein
the ratio of Sr/(Sr+Ti) at the center of the strontium titanate dielectric layer is greater than 50%.

12. The capacitor according to claim 11, wherein
a thickness of the strontium titanate dielectric layer ranges from 5 nm to 7 nm, and the ratio of Sr/(Sr+Ti) at the center ranges from 60% to 65%.

13. The capacitor according to claim 1, further comprising:

a first titanium oxide dielectric layer formed between the first electrode layer and the strontium titanate dielectric layer; and
a second titanium oxide dielectric layer formed between the second electrode layer and the strontium titanate dielectric layer.

14. The capacitor according to claim 1, further comprising:

a first aluminum titanate dielectric layer formed between the first electrode layer and the strontium titanate dielectric layer; and
a second aluminum titanate dielectric layer formed between the second electrode layer and the strontium titanate dielectric layer.

15. The capacitor according to any one of claims 1-14, wherein
each of the first electrode layer and the second electrode layer comprises a ruthenium element film layer, and the ruthenium element film layer is a metal ruthenium film layer or a ruthenium oxide film layer.

16. The capacitor according to claim 15, wherein
each of the first electrode layer and the second electrode layer further comprises a titanium nitride film layer, and the titanium nitride film layer is formed at a side of the ruthenium element film layer away from the strontium titanate dielectric layer.

17. A memory, **characterized by** comprising a substrate and the capacitor according to any one of claims 1-16, wherein the capacitor is formed on the substrate.

18. The memory according to claim 17, wherein an orthographic projection of the second electrode layer on the first electrode layer is overlapped with an orthographic projection of the strontium titanate dielectric layer on the first electrode layer, orthographic projections of the second electrode layer and the strontium titanate dielectric layer on the substrate fall within a middle area of an orthographic projection of the first electrode layer on the substrate, and the memory further comprises:

an insulation dielectric layer, covering an edge area of the first electrode layer and the second electrode layer;
an etch stop layer, formed at a side of the insulation dielectric layer away from the substrate; and
a first measurement electrode and a second measurement electrode arranged at intervals, the first measurement electrode and the second measurement electrode each comprising a via hole conduction portion and a measurement conduction portion connected with each other, wherein
the measurement conduction portion of the first measurement electrode and the measurement conduction portion of the second measurement electrode are formed at a side of the etch stop layer away from the substrate;
an orthographic projection of the via hole conduction portion of the first measurement electrode on the substrate falls within an orthographic projection of the edge area of the first electrode layer on the substrate, and the via hole conduction portion of the first measurement electrode penetrates through the etch stop layer and the insulation dielectric layer in sequence and is in contact with the edge area of the first electrode layer; and
an orthographic projection of the via hole conduction portion of the second measurement electrode on the substrate falls within the orthographic projection of the second electrode layer on the substrate, and the via hole conduction portion of the second measurement electrode penetrates through the etch stop layer and the insulation dielectric layer in sequence and is in contact with the second electrode layer.

19. The memory according to claim 18, further comprising an interlevel dielectric layer, wherein the interlevel dielectric layer is formed between the first electrode layer and the insulation dielectric layer, and the interlevel dielectric layer has a through hole to expose part of the first electrode layer;

the strontium titanate dielectric layer has a middle portion and an edge portion arranged around the middle portion, the middle portion is formed in the through hole and in contact with the first electrode layer, and the edge portion is in overlap joint to a surface of the interlevel dielectric layer away from the first electrode layer;
the via hole conduction portion of the first measurement electrode further penetrates through the interlevel dielectric layer to be in contact with the edge area of the first electrode layer while penetrating through the etch stop layer and the insulation dielectric layer; and

the orthographic projection of the via hole conduction portion of the second measurement electrode on the substrate falls within the orthographic projection of the through hole in the substrate.

20. The memory according to claim 19, wherein a plurality of via hole conduction portions are arranged in the first measurement electrode and the second measurement electrode and surround an axis of the through hole at equal intervals.

21. The memory according to claim 17, wherein the substrate comprises a semiconductor base and an insulation isolation layer, the insulation isolation layer is formed between the first electrode layer and the semiconductor base.

22. A manufacturing method of a memory, comprising:

providing a substrate;
forming a first electrode layer on the substrate;
forming a strontium titanate dielectric layer at a side of the first electrode layer away from the substrate, wherein in a direction from a center of the strontium titanate dielectric layer to two opposite sides of the strontium titanate dielectric layer, ratios of Sr/(Sr+Ti) in the strontium titanate dielectric layer decrease gradually, one side of the two opposite sides in the strontium titanate dielectric layer is close to the first electrode layer and the other side of the two opposite sides in the strontium titanate dielectric layer is away from the first electrode layer; and
forming a second electrode layer at a side of the strontium titanate dielectric layer away from the first electrode layer to form a capacitor.

23. The manufacturing method according to claim 22, wherein the step of forming the strontium titanate dielectric layer at the side of the first electrode layer away from the substrate comprises:

depositing a strontium titanate material at the side of the first electrode layer away from the substrate through a primary atomic layer deposition process to form the strontium titanate dielectric layer;
wherein in the primary atomic layer deposition process, the ratios of Sr/(Sr+Ti) in the strontium titanate material increase gradually and decrease gradually successively according to a set rule by adjusting a flow of an Sr precursor and/or a Ti precursor.

24. The manufacturing method according to claim 22, wherein the step of forming the strontium titanate dielectric layer at the side of the first electrode layer away from the substrate comprises:
forming N strontium titanate film layers stacked in sequence at the side of the first electrode layer away from the substrate through N atomic layer deposition processes to form the strontium titanate dielectric layer, wherein N is a positive integer greater than or equal to 3.

25. The manufacturing method according to claim 22, wherein

prior to the step of forming the strontium titanate dielectric layer at the side of the first electrode layer away from the substrate, the manufacturing method further comprises: forming a first titanium oxide dielectric layer at the side of the first electrode layer away from the substrate; and
prior to the step of forming the second electrode layer at the side of the strontium titanate dielectric layer away from the first electrode layer, the manufacturing method further comprises: forming a second titanium oxide dielectric layer at the side of the first electrode layer away from the strontium titanate dielectric layer.

26. The manufacturing method according to claim 22, wherein

prior to the step of forming the strontium titanate dielectric layer at the side of the first electrode layer away from the substrate, the method further comprises: forming a first aluminum titanate dielectric layer at the side of the first electrode layer away from the substrate; and
prior to the step of forming the second electrode layer at the side of the strontium titanate dielectric layer away from the first electrode layer, the method further comprises: forming a second aluminum titanate dielectric layer at the side of the strontium titanate dielectric layer away from the first electrode layer.

27. The manufacturing method according to claim 26, wherein

the step of forming the first aluminum titanate dielectric layer at the side of the first electrode layer away from the substrate comprises: forming a first titanium oxide dielectric layer at the side of the first electrode layer away from the substrate and then doping an aluminum element into the first titanium oxide dielectric layer to form the first aluminum titanate dielectric layer; and

the step of forming the second aluminum titanate dielectric layer at the side of the strontium titanate dielectric layer away from the first electrode layer comprises:

forming a second titanium oxide dielectric layer at the side of the strontium titanate dielectric layer away from the first electrode layer and then doping an aluminum element into the second titanium oxide dielectric layer to form the second aluminum titanate dielectric layer.

28. The manufacturing method according to claim 22, wherein prior to the step of forming the strontium titanate dielectric layer at the side of the first electrode layer away from the substrate, the method further comprises: forming an interlevel dielectric material film at the side of the first electrode layer away from the substrate; and

forming a through hole through which a middle area of the first electrode layer is exposed in the interlevel dielectric material film through a patterning treatment process to form an interlevel dielectric layer; wherein at least part of the strontium titanate dielectric layer is located in the through hole and in contact with the first electrode layer.

29. The manufacturing method according to claim 28, wherein the step of forming the strontium titanate dielectric layer and the second electrode layer in sequence at the side of the first electrode layer away from the substrate comprises:

after forming the interlevel dielectric layer, forming a strontium titanate dielectric material film and a second electrode material film located in the through hole and covering the interlevel dielectric layer in sequence; and removing portions of the strontium titanate dielectric material film and the second electrode material film that cover the interlevel dielectric layer to form the strontium titanate dielectric layer and the second electrode layer.

30. The manufacturing method according to claim 29, wherein after the step of forming the strontium titanate dielectric layer and the second electrode layer in sequence at the side of the first electrode layer away from the substrate, the manufacturing method further comprises:

forming an insulation dielectric layer and an etch stop layer in sequence at the sides of the interlevel dielectric layer and the second electrode layer away from the substrate; forming a first via hole and a second via hole formed at intervals, wherein an orthographic projection of the first via hole in the substrate falls within an orthographic projection of an edge area of the first electrode layer on the substrate, and is non-overlapped with orthographic projections of the second electrode layer and the strontium titanate dielectric layer on the substrate, wherein the first via hole penetrates through the insulation dielectric layer, the etch stop layer and the interlevel dielectric layer in sequence and exposes part of the first electrode layer, wherein an orthographic projection of the second via hole falls within an orthographic projection of the through hole in the substrate, the second via hole penetrates through the insulation dielectric layer and the etch stop layer in sequence, and exposes part of the second electrode layer; forming a measurement electrode material film, wherein the measurement electrode material film covers a surface of the etch stop layer away from the insulation dielectric layer and fills the first via hole and the second via hole; and performing patterning treatment on the measurement electrode material film to form a first measurement electrode and a second measurement electrode, wherein each of the first measurement electrode and the second measurement electrode comprises a via hole conduction portion and a measurement conduction portion, the measurement conduction portion of the first measurement electrode and the measurement conduction portion of the second measurement electrode are arranged at intervals and are formed at the side of the etch stop layer away from the substrate, the measurement conduction portion of the first measurement electrode is a measurement electrode material film that fills the first via hole, and the measurement conduction portion of the second measurement electrode is a measurement electrode material film that fills the second via hole.

FIG. 1

FIG. 2

FIG. 3

FIG. 4

FIG. 5

FIG. 6

FIG. 7

FIG. 8

FIG. 9

Y axis

C

H/2                    0                    H/2        X axis

FIG. 10

11

11b
11a ⎫ 112
1110

a2

a1

11a
11b ⎫ 110

FIG. 11

11

11b ⎫ 112
11a ⎭
1110 ⎫
1110 ⎬ 1110
1110 ⎭
11a ⎫ 110
11b ⎭

FIG. 12

11

11b ⎫ 112
11a ⎭
1112 ⎫
1110 ⎫ 1110 ⎬ 111
1110 ⎬ 1110 ⎭
1110 ⎭
1111 ⎭
11a ⎫ 110
11b ⎭

FIG. 13

11

11b ⎫ 112
11a ⎭
1114 ⎫
1110 ⎫
1110 ⎬ 1110 ⎬ 111
1110 ⎭
1113 ⎭
11a ⎫ 110
11b ⎭

FIG. 14

FIG. 15

FIG. 16

FIG. 17

FIG. 18

FIG. 19

FIG. 20

FIG. 21

FIG. 22

FIG. 23

FIG. 24

FIG. 25

EP 4 531 533 A1

## INTERNATIONAL SEARCH REPORT

International application No.

**PCT/CN2024/094149**

### A. CLASSIFICATION OF SUBJECT MATTER

H10N 97/00(2023.01)i; H10B 12/00(2023.01)i

According to International Patent Classification (IPC) or to both national classification and IPC

### B. FIELDS SEARCHED

Minimum documentation searched (classification system followed by classification symbols)

IPC: H01L H10N H10B

Documentation searched other than minimum documentation to the extent that such documents are included in the fields searched

Electronic data base consulted during the international search (name of data base and, where practicable, search terms used)

CNTXT, ENTXTC, ENTXT, DWPI, CNKI: 动态, 存储, 电容器, 钛酸锶, 含量, 浓度, 百分比, 递增, 增加, 升高, 递减, 减小, 减少, 降低, 渐变, dynamic, memory, DRAM, capacitor, SrTiO3, STO, content, concentration, percent, increas+, decreas+, grad+

### C. DOCUMENTS CONSIDERED TO BE RELEVANT

| Category* | Citation of document, with indication, where appropriate, of the relevant passages | Relevant to claim No. |
|---|---|---|
| A | US 2013122682 A1 (DEWEERD WIM et al.) 16 May 2013 (2013-05-16) entire document | 1-30 |
| A | CN 106328376 A (ASUSTEK COMPUTER INC.) 11 January 2017 (2017-01-11) entire document | 1-30 |
| A | CN 110660583 A (INSTITUTE OF FLEXIBLE ELECTRONICS TECHNOLOGY OF THU, ZHEJIANG et al.) 07 January 2020 (2020-01-07) entire document | 1-30 |
| A | CN 108447983 A (SOUTHWEST UNIVERSITY) 24 August 2018 (2018-08-24) entire document | 1-30 |

☐ Further documents are listed in the continuation of Box C.   ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **12 August 2024** | **15 August 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

International application No.

**PCT/CN2024/094149**

| Patent document cited in search report | | | Publication date (day/month/year) | Patent family member(s) | | | Publication date (day/month/year) |
|---|---|---|---|---|---|---|---|
| US | 2013122682 | A1 | 16 May 2013 | US | 8647960 | B2 | 11 February 2014 |
| CN | 106328376 | A | 11 January 2017 | None | | | |
| CN | 110660583 | A | 07 January 2020 | None | | | |
| CN | 108447983 | A | 24 August 2018 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310924147

- CN 202321986642